# EUROPEAN PATENT APPLICATION

(11) **EP 3 505 941 A1**
(43) Date of publication of application: **03.07.2019**
(21) Application number: 19150015.6
(22) Date of filing: 02.01.2019
(51) Int. Cl.: G01R 13/24, G01R 13/02, G01R 13/30

(54) **NETWORK OSCILLOSCOPE USING PACKET TIMESTAMPS**

(30) Priority: 02.01.2018 US 201862613015 P; 30.11.2018 US 201816206997
(71) Applicant: Tektronix, Inc., Beaverton, OR 97077-0001 (US)
(72) Inventor: CHABRECK, Thomas, Tigard, OR 97224 (US); TUSING, George, Portland, OR 97225 (US); OVERTON, Michael, Beaverton, OR 97008 (US)
(74) Representative: HGF Limited

(57) **Abstract**

A network oscilloscope, including a network interface configured to receive a stream of network data, one or more processors, and a display. The one or more processors generate a timestamp for each data packet parsed from the stream of network data, extract a portion of information from each of the data packets received from the stream of network data, the portion of information being less than an entirety of information in each data packet, and generate a data record indicating extracted information and a timestamp for each data packet parsed from the stream of network data. The display configured to display at least a portion of the data record.

## Description

### PRIORITY

This disclosure claims benefit of U.S. Provisional Application No. 62/613,015, titled "Network Oscilloscope Using Packet Timestamps," filed on January 2, 2018, which is incorporated herein by reference in its entirety.

### FIELD OF THE INVENTION

This disclosure is directed to systems and methods related to test and measurement instruments, and in particular, to a test and measurement instrument that analyzes and displays packets of data for high speed networks.

### BACKGROUND

Networks, such as Ethernet based networks, may be employed to carry almost any type of information due to the low cost per bit and rapid improvement in performance of these networks. In particular, live production of video and audio has transitioned to a network-based transport mechanism. These signals may have synchronous characteristics that should be accommodated and preserved. Preserving these synchronous characteristics can present a challenge when such signals are transported over an asynchronous packet-based network, such as Ethernet, where various data flows interact and compete for bandwidth and priority in queues. To deal with potential issues on the network, it can be beneficial to run tests to determine what is happening on the network. However, conventional network analyzers may not allow a user to view what is happening on the network and can only provide a small portion of useful information.

### BRIEF DESCRIPTION OF THE DRAWINGS

Aspects, features and advantages of embodiments of the present disclosure will become apparent from the following description of embodiments in reference to the appended drawings in which:
Fig. 1 is a block diagram of a test and measurement instrument according to some embodiments of the disclosure.
Fig. 2 is a flow chart illustrating an example operation of embodiments of the disclosure.
Fig. 3 is a block diagram illustrating an operation of the parser of Fig. 1.
Fig. 4 is an example display output according to some embodiments of the disclosure.

### DESCRIPTION

Disclosed herein is a network oscilloscope, including a network interface configured to receive a stream of network data from a high-speed network, such as ten Gigabit Ethernet (10 Ge) or greater, and one or more processors configured to generate a timestamp for each data packet parsed from the stream of network data, extract information from each of the data packets received from the stream of network data, generate a data record indicating extracted information and a timestamp for each data packet parsed from the stream of network data. The network oscilloscope also includes a display configured to display at least a portion of the data record, which can allow a user to view what is happening on the network and potentially diagnose any errors occurring on the network.

It would be beneficial to test a network by putting a traditional oscilloscope on the network and identifying the timing of the packets of the various sources and data types to see what is happening on the network. A traditional oscilloscope, however, is only able to sample the voltage on the network and, further, may be unable to perform such processes at the high data rates employed by such networks. For example, networks in an audio/video (A/V) production environment may operate at rates up to 10 Ge, 100 Ge, and even 400 Ge. These high speed network data rates may result in the traditional oscilloscope being unable to decode the packets to identify the type and source of the packet at such speeds.

The current disclosure herein is advantageous by using a test instrument that is capable of decoding network packets and/or applying timestamps to arrange the packets into a virtual oscilloscope view of the network traffic. This allows a user to view what is happening on the network in real time or near real time, rather than merely sampling the voltage traversing the network cable, as would be done by a traditional oscilloscope. Embodiments disclosed herein are able to provide, in real time or non-real time, a display similar to a traditional oscilloscope display, with additional information, at the high data rates employed in an A/V production environment or other high data rate environments.

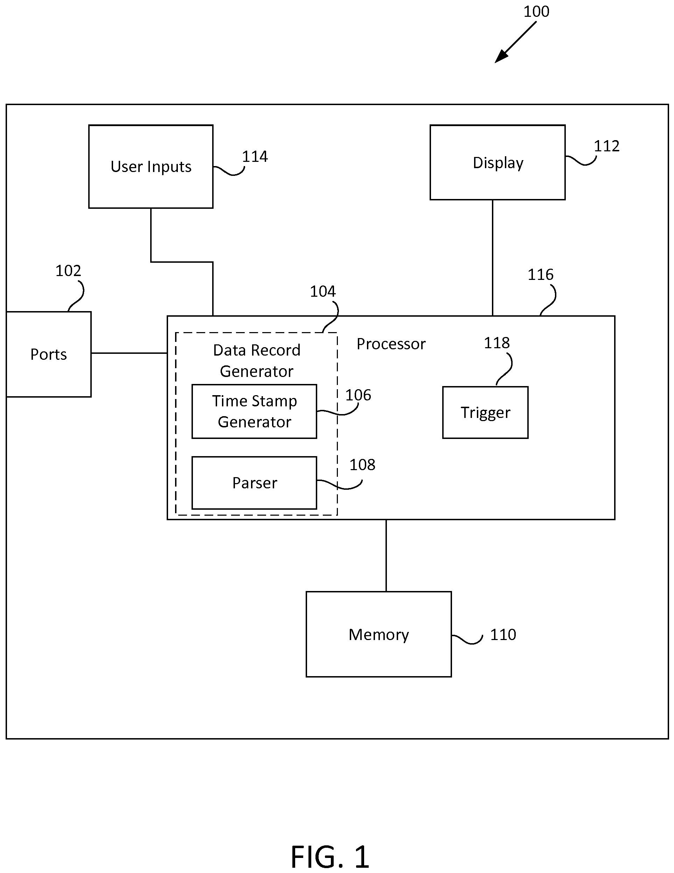

Fig. 1 is a block diagram of an example test instrument 100, such as a packet-based oscilloscope, for implementing embodiments of the disclosure disclosed herein. The instrument 100 includes a plurality of ports 102 which may be any electrical signaling medium and may act as a network interface. Ports 102 may include receivers, transmitters, and/or transceivers. The ports 102 are connected to a network to receive data from various incoming network stream(s). The ports 102 are coupled with one or more processors 116. The one or more processors 116 may include a data record generator 104, which may include a timestamp generator 106 and a parser 108, as well as a trigger 118, among other components. The data record generator 104 generates a data record from the received packets that can identify pertinent information for desired triggering or event detection. The ports 102 may also receive additional signals, which may be processed through the data record generator 104 and/or another processor (not shown) in the test instrument 100 that may be used as triggering signals, which will be discussed in more detail below. In some embodiments, the data record generator 104 may only display a portion of the data record when a triggering event occurs. For example, an optional trigger 118 may be provided in the one or more processors 116, which can receive the data record or any other signal from the one or more ports 102, and either instruct the display 112 to display a portion of the data record based on the trigger and/or instruct memory 110 to store a portion of the data record based on the triggering event. Storage of the data record may be based on a predetermined time period around the trigger signal or may be based on a number of bytes surrounding the trigger signal, for example. Although only one processors 116 is shown in Fig. 1 for ease of illustration, as will be understood by one skilled in the art, multiple processors of varying types may be used in combination, rather than a single processor 116.

The timestamp generator 106 can apply, or associate, a timestamp with packets received by the ports 102. The stream of data received by the ports 102 may be received at a data rate of 10 gigabits per second or greater. The timestamp reflects the time at which the individual packets were received by the test instrument 100 and can be utilized (e.g., by the data record generator 104) in generating an oscilloscope-type time-domain display depicting the packets received, as will be discussed in more detail below. The timestamps may also be used to recover timing as per Institute of Electrical and Electronics Engineers (IEEE) 1588 Precision Time Protocol (PTP) and, in the case of some test and measurement devices, such as the Tektronix MPI3000 Monitor, the timestamps may be used to derive packet interval time trend and histogram displays.

The parser 108 parses data from the packets on the network stream to generate a data record which may be used to create a display similar to a traditional oscilloscope display for easier viewing and review by a user of the data. For example, the parser 108 may parse data from the packets on the network stream and the parsed data, along with the timestamps of the packets, is used to create a data record. The information may include the packet type, the source information, the size, and any other data needed to support correlation of the packet to other events and/or packets. However, the extracted information is not limited to the above discussed types of data, rather, any information that is in the parsed data packet may be extracted.

The data record may be continuously streaming data, a capture of a specified time duration, a number of bytes from the network interface, and/or any other suitable output produced from the parsed data of the network stream(s). In some embodiments, the data record may not employ all the available data. This allows a smaller subset of the overall data flow to be captured and displayed as representative of the higher data rate A/V flows, thus reducing the amount of processing that each packet is subject to. This reduced processing allows the data to be captured in real time or near real time. As an example, the data record may include a timestamp for the packet (e.g., the start of the packet), the packet type, the source information, the size, and any other data needed to support correlation of the packet to other events and/or packets. The size of the subset of the data employed may be selected by a user, as desired, based on the speed and capabilities of the test instrument 100.

The ports 102 can also be connected to a measurement unit in the test instrument 100, not depicted. Such a measurement unit can include any component capable of measuring aspects (e.g., voltage, amperage, amplitude, etc.) of a signal received via ports 102. The packet pipeline depicted by ports 102 through a processor and/or data record generator 104 can include conditioning circuits, an analog to digital converter, and/or other circuitry to convert a received signal to a waveform for further analysis. The resulting waveform can then be stored in the memory 110 along with the data record for the packet that generated the waveform and/or the packet that generated the waveform.

The data record generator 104 may be implemented as any processing circuity, such as an application specific integrated circuit (ASIC), a digital signal processor (DSP), a field programmable gate array (FPGA), etc. In some embodiments, the data record generator 104 may be configured to execute instructions from memory 110 and may perform any methods and/or associated steps indicated by such instructions. Memory 110 may be implemented as processor cache, random access memory (RAM), read only memory (ROM), solid state memory, hard disk drive(s), or any other memory type. Memory 110 acts as a medium for storing data, computer program products, and other instructions, and providing such data/products/instruction to the data record generator 104 for computation as desired. Memory 110 also stores measured signal responses (e.g. waveforms), timestamps, packet classification information such as the above discussed data record, and/or other network data for use by the data record generator 104.

User inputs 114 are coupled to the data record generator 104. User inputs 114 may include a keyboard, mouse, trackball, touchscreen, and/or any other controls employable by a user to interact with the data record generator 104 via a GUI on a display 112. The display 112 may be a digital screen, a cathode ray tube based display, or any other monitor to display test results, timestamps, packet time lines, or other results to a user as discussed herein. While the components of test instrument 100 are depicted as being integrated with test instrument 100, it will be appreciated by a person of ordinary skill in the art that any of these components can be external to test instrument 100 and can be coupled to test instrument 100 in any conventional manner (e.g., wired and/or wireless communication media and/or mechanisms).

In some embodiments of the disclosure, the test and measurement instrument 100 may include a separate processor (not shown) connected to the data record generator 104. In some embodiments, the data record generator 104 may connect to the memory 110, display 112, and user inputs 114 through the separate processor, as will be understood by one skilled in the art.

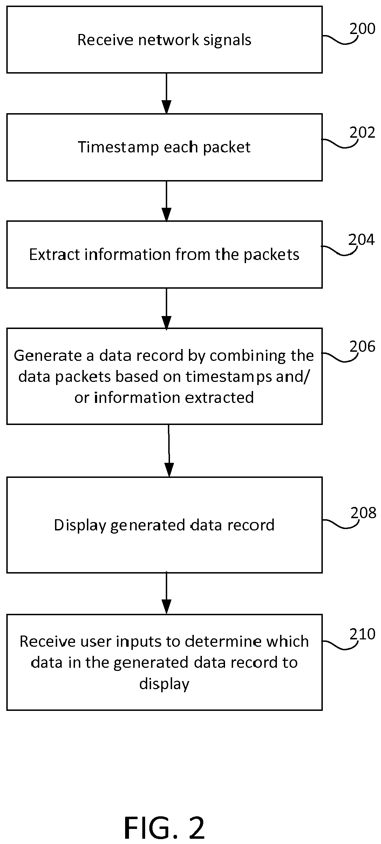

Fig. 2 is a flow chart illustrating an example operation of the test and measurement instrument 100, according to some embodiments. Initially, network signals are received at ports 102 in operation 200 over one or more network cables. The timestamp generator 106 generates a timestamp for each data packet as it is received over the network in operation 202. In operation 204, data or information is extracted by parser 108 from each of the data packets received at the ports 102, such as the packet type, packet size, source information, size, and/or other data to allow correlation to other events. However, the extracted information is not limited to the above discussed types, rather, any information that is in the parsed data packet may be extracted. As mentioned above, which data is extracted may vary based on the data speed, processing speed of the test instrument 100, and the information desired by the user.

As mentioned above, the parsing of the data may be done for continuous streaming data, data captured at a given time or event, or a number of bytes or packets from the network interface based on a particular time or event.

In operation 206, the data record generator 104 generates a data record by combining the parsed packets based on their timestamp and/or the information extracted from the parsed packets. The data record generator 104 preferably generates the data record in order and spaced in accordance to the timestamp so a user can see what is happening on the network in real time or near real time. That is, the data record may be generated on a timeline according to each packet's timestamps and length to illustrate the occupancy of the network connection. However, other orders may be designated by the user in the user inputs 114 to display the data based on the parsed packets. In operation 208, the generated data record may be displayed to a user on display 112. In operation 210, which can occur concurrently with or before operation 208, user inputs 114 are received to determine which information from the data record the user wants to review. The one or more processors 116 may then modify the displayed data to only display the relevant information to the user, such as packets only from certain sources, packets of certain size, etc.

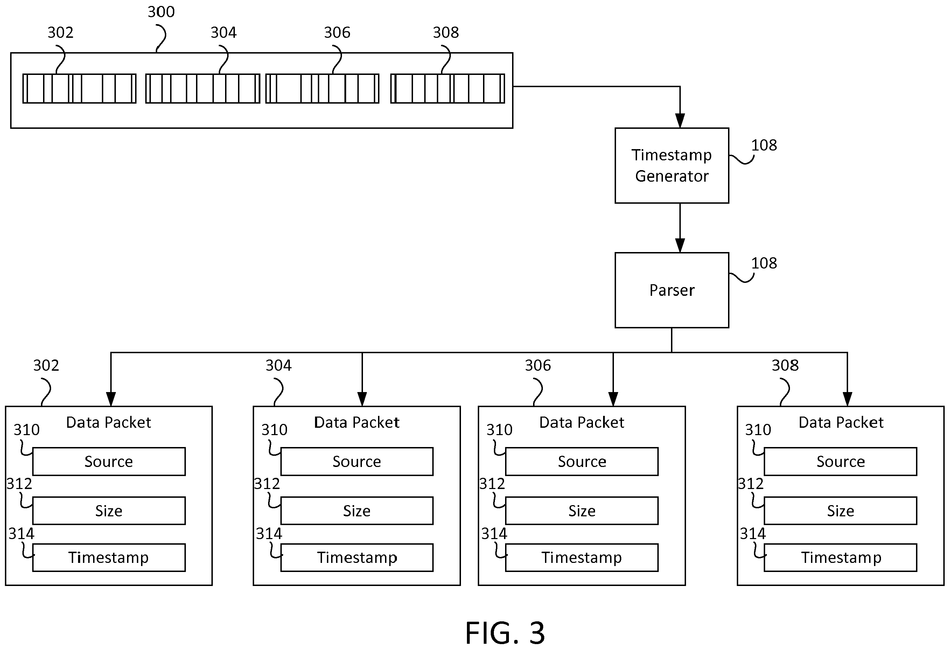

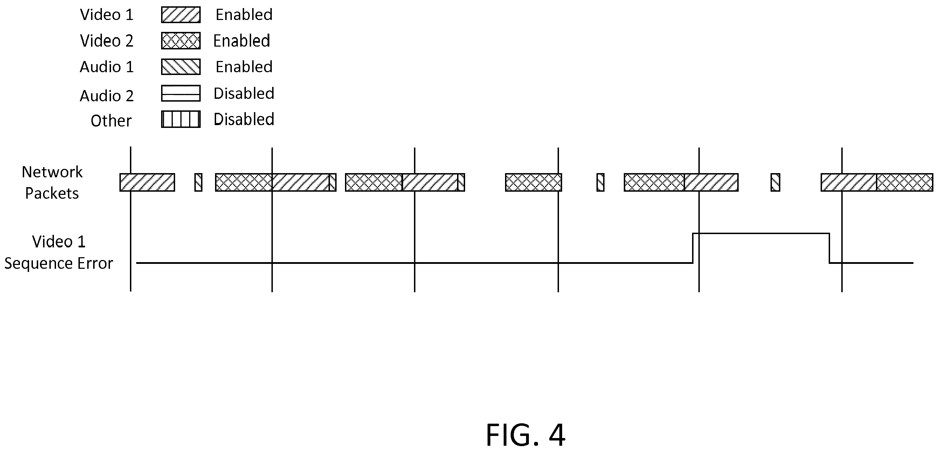

Fig. 3 illustrates an operation of the timestamp generator 106 and the parser 108. The timestamp generator 106 may first receive the data 300 to provide a timestamp for each packet, including data packets 302, 304, 306, and 308. The parser 108 then receives the timestamped data packets 302, 304, 306, and 308. Although only four data packets 302, 304, 306, and 308 are shown, it will be readily understood by one skilled in the art that many data packets may be present on the network and received at one or more ports 102. The parser 108 then parses the timestamped data packets 302, 304, 306, and 308 to extract information. In the example of Fig. 3, the source 310 and the size 312 of the data packets 302, 304, 306, and 308 are extracted. The timestamp 314 is also illustrated as part of the extracted data. However, as will be understood by one skilled in the art, the timestamp 314 may be associated with each data packet separate from the parsed data. Then, this data may be used, along with the timestamp 314 generated by the timestamp generator 106, to display the packets in order, as well as based on source, size, length, etc., as shown in Fig. 4.

As can be seen in Fig. 3, each data packet 302, 304, 306, and 308 may not need to be parsed completely, rather, just the information desired by the user may be extracted from the data packets 302, 304, 306, and 308. The information to be extracted may be set by a user in the user inputs 114. This can decrease the processing time since not all of the data in each data packet needs to be parsed.

Fig. 4 illustrates an example display of packet information according to embodiments of the disclosure. As seen, the network packets are displayed on a timeline based on the timestamps of the packet, and indicate the size and source of the network packet. In Fig. 4, the vertical bars on the displayed timeline illustrate horizontal divisions, similar to an oscilloscope, and the amount of time per division may be adjusted by a user via the user inputs 114. The horizontal time scale of the example illustrated in Fig. 4 is 5 milliseconds/division. This can allow a user to visualize how the data is being sent and received on the network and potentially diagnose any issues with the received data. In this example, a user can toggle various network sources on ("enabled") and off ("disabled"), so that only relevant or desired network sources are viewed. That is, neither "audio 2" or "other" are enabled on the display shown in Fig. 4, and therefore are not shown on the timeline. Other associated signals or trigger signals may also be present, which will be discussed in further detail below.

While the data record generator 104 is generating the data record as network packets are received at the ports 102, the data may be displayed on the display in response to a trigger signal from the trigger 118, as seen in Fig. 4. That is, the display 112 could be updated periodically either based on a triggered or un-triggered mode, or it could capture and display only when a trigger occurs. Many types of triggers may be used, such as when the time between packets of a given flow is less than a time threshold, or a size of a packet. Other example triggers are possible, such as if a burst of a given number, or great than a number, of packets occurs within a given interval or a first packet type followed by a second packet type, etc. Further, multiple triggers may be used, rather than just a single trigger. Many other triggers may be used depending on the information extracted from the packets.

As seen in Fig. 4, the display of data can also be triggered by or correlated to other events, such as a sequence error or a buffer fullness error. These events can be shown as another trace on the display, such as seen in Fig. 4. The user can input the desired trigger into the user input 114, which can help the user decode various problems occurring and see what is happening on the network during those problems. This allows a user to see much more data than is current available with a traditional oscilloscope, which is only capable of displaying voltage on the network. As mentioned above, when a trigger occurs, data packets captured before and/or after the trigger may be displayed. The time frame or number of bytes may be set by a user in the user inputs 114.

Aspects of the disclosure may operate on particularly created hardware, firmware, digital signal processors, or on a specially programmed computer including a processor operating according to programmed instructions. The terms controller or processor as used herein are intended to include microprocessors, microcomputers, Application Specific Integrated Circuits (ASICs), and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a computer readable storage medium such as a hard disk, optical disk, removable storage media, solid state memory, Random Access Memory (RAM), etc. As will be appreciated by one of skill in the art, the functionality of the program modules may be combined or distributed as desired in various aspects. In addition, the functionality may be embodied in whole or in part in firmware or hardware equivalents such as integrated circuits, FPGA, and the like. Particular data structures may be used to more effectively implement one or more aspects of the disclosure, and such data structures are contemplated within the scope of computer executable instructions and computer-usable data described herein.

The disclosed aspects may be implemented, in some cases, in hardware, firmware, software, or any combination thereof. The disclosed aspects may also be implemented as instructions carried by or stored on one or more or computer-readable storage media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include RAM, ROM, Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

Illustrative examples of the technologies disclosed herein are provided below. An embodiment of the technologies may include any one or more, and any combination of, the examples described below.
Example 1 a network oscilloscope, comprising a network interface configured to receive a stream of network data; one or more processors configured to generate a timestamp for each data packet parsed from the stream of network data, extract a portion of information from each of the data packets received from the stream of network data, the portion of information being less than an entirety of information in each respective data packet, generate a data record indicating extracted information and a timestamp for each data packet parsed from the stream of network data, and arrange the data record based on at least the portion of the extracted information or the timestamp; and a display configured to display at least a portion of the arranged data record.
Example 2 is the network oscilloscope of example 1, further comprising an input configured to receive a signal, wherein the display is configured to display at least a portion of the arranged data record concurrently with the signal.
Example 3 is the network oscilloscope of either one of examples 1 and 2, wherein the portion of information includes at least one of packet type, packet size, a packet length, or source information.
Example 4 is the network oscilloscope of example 3, wherein the display is configured to display at least the portion of the data record on a timeline based on the timestamp and the packet length of each of the data packets.
Example 5 is the network oscilloscope of any one of examples 1-4, further comprising user inputs configured to receive a selection from a user, wherein the display is configured to display at least the portion of the data record based on the selection from the user.
Example 6 is the network oscilloscope of any one of examples 1-5, wherein the one or more processors are further configured to detect a trigger event and the display is further configured to display the portion of the data record based on the trigger event.
Example 7 is the network oscilloscope of example 6, wherein the one or more processors are further configured to store the data record in a memory for a predetermined period of time or a predetermined number of bytes based on the trigger event.
Example 8 is the network oscilloscope of either one of example 6 or 7, wherein the display is further configured to display the trigger event concurrently with the portion of the data record.
Example 9 is the network oscilloscope of any one of examples 6-8, wherein the network interface is further configured to receive a second stream of data and the trigger event is detected on the second stream of data.
Example 10 is the network oscilloscope of example 9, wherein the display is further configured to display the second stream of data concurrently with the portion of the data record.
Example 11 is the network oscilloscope of any one of examples 1-10, wherein the stream of network data is received at a rate of ten gigabits per second or greater.
Example 12 is a method for use by a test and measurement instrument coupled to a high speed network, comprising receiving a stream of network data, the stream of network data including a plurality of data packets; detecting a trigger event; determining a timestamp for each data packet received in the stream of network data; extracting a portion of information from each of the data packets received in the stream of network data, generating a data record, the data record including extracted information and a timestamp for each data packet received in the stream of network data, and displaying at least a portion of the data record based on the trigger event.
Example 13 is the method of example 12, wherein the trigger event is detected on the stream of network data.
Example 14 is the method of either one of examples 12 and 13, wherein the portion of information includes at least one of packet type, packet size, packet length, or source information.
Example 15 is the method of any one of examples 12-14, wherein the portion of information is less than an entirety of information in each respective data packet.
Example 16 is the method of any one of examples 12-15, further comprising receiving a user input, the user input including an indication of the portion of information to extract from each of the respective data packets.
Example 17 is the method of any one of examples 12-16, further comprising receiving a selection from a user via user inputs, and displaying at least the portion of the data record includes displaying at least the portion of the data record based on the selection from the user.
Example 18 is the method of any one of examples 12-17, further comprising receiving a signal, wherein the trigger event is detected within the signal.
Example 19 is the method of example 18, further comprising displaying the signal concurrently with the data record.
Example 20 is the method of either one of examples 18 or 19, further comprising storing in a memory the data record for a predetermined period of time or a predetermined number of bytes based on the trigger event.

The previously described versions of the disclosed subject matter have many advantages that were either described or would be apparent to a person of ordinary skill. Even so, these advantages or features are not required in all versions of the disclosed apparatus, systems, or methods.

Additionally, this written description makes reference to particular features. It is to be understood that the disclosure in this specification includes all possible combinations of those particular features. Where a particular feature is disclosed in the context of a particular aspect or example, that feature can also be used, to the extent possible, in the context of other aspects and examples.

Also, when reference is made in this application to a method having two or more defined steps or operations, the defined steps or operations can be carried out in any order or simultaneously, unless the context excludes those possibilities.

Although specific examples of the invention have been illustrated and described for purposes of illustration, it will be understood that various modifications may be made without departing from the scope of the invention. Accordingly, the invention should not be limited except as by the appended claims.

## Claims

1. A network oscilloscope, comprising:
a network interface configured to receive a stream of network data;
one or more processors configured to:
generate a timestamp for each data packet parsed from the stream of network data,
extract a portion of information from each of the data packets received from the stream of network data, the portion of information being less than an entirety of information in each respective data packet,
generate a data record indicating extracted information and a timestamp for each data packet parsed from the stream of network data, and
arrange the data record based on at least the portion of the extracted information or the timestamp; and
a display configured to display at least a portion of the arranged data record.

2. The network oscilloscope of claim 1, further comprising:
an input configured to receive a signal, wherein the display is configured to display at least a portion of the arranged data record concurrently with the signal; and/or
user inputs configured to receive a selection from a user, wherein the display is configured to display at least the portion of the data record based on the selection from the user.

3. The network oscilloscope of claim 1 or 2, wherein the portion of information includes at least one of packet type, packet size, a packet length, or source information.

4. The network oscilloscope of claim 3, wherein the display is configured to display at least the portion of the data record on a timeline based on the timestamp and the packet length of each of the data packets.

5. The network oscilloscope of any of claims 1 to 4, wherein the one or more processors are further configured to detect a trigger event and the display is further configured to display the portion of the data record based on the trigger event; and/or

6. The network oscilloscope of claim 5, wherein the one or more processors are further configured to store the data record in a memory for a predetermined period of time or a predetermined number of bytes based on the trigger event; and/or
wherein the display is further configured to display the trigger event concurrently with the portion of the data record; and/or
wherein the network interface is further configured to receive a second stream of data and the trigger event is detected on the second stream of data.

7. The network oscilloscope of claim 6, wherein the display is further configured to display the second stream of data concurrently with the portion of the data record.

8. The network oscilloscope of any preceding claim, wherein the stream of network data is received at a rate of ten gigabits per second or greater.

9. A method for use by a test and measurement instrument coupled to a high speed network, comprising:
receiving a stream of network data, the stream of network data including a plurality of data packets;
detecting a trigger event;
determining a timestamp for each data packet received in the stream of network data;
extracting a portion of information from each of the data packets received in the stream of network data,
generating a data record, the data record including extracted information and a timestamp for each data packet received in the stream of network data, and
displaying at least a portion of the data record based on the trigger event.

10. The method of claim 9, wherein:
the trigger event is detected on the stream of network data; and/or
the portion of information includes at least one of packet type, packet size, packet length, or source information; and/or
the portion of information is less than an entirety of information in each respective data packet.

11. The method of claim 9 or 10, further comprising receiving a user input, the user input including an indication of the portion of information to extract from each of the respective data packets.

12. The method of any of claims 9 to 11, further comprising receiving a selection from a user via user inputs, and displaying at least the portion of the data record includes displaying at least the portion of the data record based on the selection from the user.

13. The method of any of claims 9 to 12, further comprising receiving a signal, wherein the trigger event is detected within the signal.

14. The method of claim 13, further comprising displaying the signal concurrently with the data record.

15. The method of claim 13 or 14, further comprising storing in a memory the data record for a predetermined period of time or a predetermined number of bytes based on the trigger event.
